Europäisches Patentamt

(19) European Patent Office

Office européen des brevets

(11) Publication number:

# 0012547
## A1

# EUROPEAN PATENT APPLICATION

㉑ Application number: 79302752.5

㉒ Date of filing: 03.12.79

(51) Int. Cl.³: **B 60 L 15/00, H 02 H 7/20, H 03 K 17/08**

㉚ Priority: 18.12.78 US 970469

㊸ Date of publication of application: 25.06.80 Bulletin 80/13

㊽ Designated Contracting States: **DE FR GB**

㉚ Applicant: **Allis-Chalmers Corporation, P.O. Box 512, Milwaukee, Wisconsin 53201 (US)**

㉒ Inventor: **Stich, Frederick Alan, 2665 North Lake Drive, Milwaukee, Wisconsin (US)**

㊹ Representative: **Grundy, Derek George Ritchie et al, CARPMAELS & RANSFORD 43, Bloomsbury Square, London WC1A 2RA (GB)**

(54) Conduction limit protection arrangement for power transistor switch.

(57) The invention relates to a protective arrangement for a power transistor switch in a brushless type electric motor traction drive used in lift trucks.

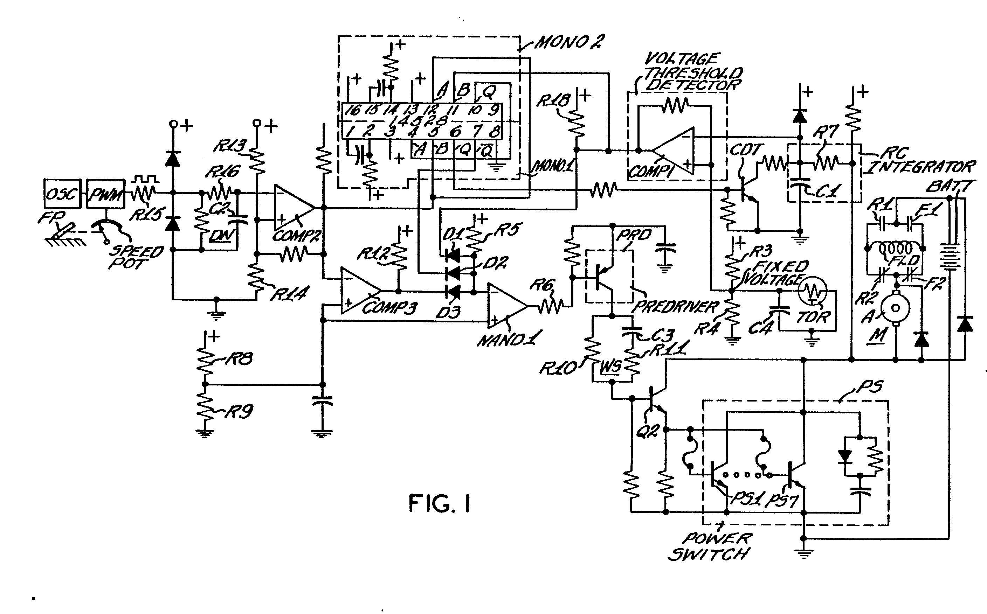

The power transistor switch (PS) (which may comprise a plurality of paralleled power transistors PS1–PS7, Fig. 1), supplies power to a DC series electric traction motor (M) and is regulated by a train of control pulses from a pulse width modulation control (PWM) to selectively vary the speed of motor (M). The conduction limit protective arrangement of the invention automatically changes the conduction limit for transistor switch (PS) as a function of the voltage, current and temperature conditions to which switch (PS) is subjected so that it is within its safe operating area at all times, thereby permitting switch (PS) to carry maximum current while being fully protected at all times. When power switch (PS) experiences abnormal current, timing capacitor (C1) is charged at a rate dependent upon (VCE) across switch (PS), and when the voltage on (C1) exceeds the fixed threshold value, comparator (COMP 1) provides an output signal to gate (NAND 1) which is opened in response thereto to turn off predriver transistor (PRD) and thereby remove the control pulse from switch (PS).

Consequently, if power switch (PS) experiences abnormally high on-voltage, it is turned off after a time interval which is a function of its collector-to-emitter voltage.

ACTORUM AG

# CONDUCTION LIMIT PROTECTION ARRANGEMENT
## FOR POWER TRANSISTOR SWITCH

This invention relates to the protection of power transistor switches during overload conditions.

Variable duty cycle controls are known wherein a power transistor switch in series with an electrical power source and a load is periodically turned on and off to regulate the average voltage supplied to the load. Change in load in such variable duty cycle control may draw more current from the transistor switch and cause it to experience abnormally high "on" voltages and move further into the active region with resultant increased voltage drop across the switch and increased heat losses that may damage the transistor switch and cause it to fail. Protection circuits, such as disclosed in United States patent 3,855,520, are known for preventing failure of a transistor power switch utilizing conduction limit means responsive to the voltage across the power switch exceeding a predetermined magnitude for reducing the duty cycle of the control pulses that turn the power transistor switch on and off. Such conduction limit protective circuit is based upon the fact that the voltage drop across the transistor power switch increases rapidly at currents in excess of design limits because the base drive current is not sufficient to maintain low on-voltage at higher current, and such conduction limit protective circuit utilizes a voltage threshold detector to sense the collector-to-emitter voltage drop ($V_{CE}$) across the power transistor switch and turn it off at high $V_{CE}$ values. Such conduction limit protective circuit tends to latch the power switch in the off state and consequently requires means to turn the transistor power switch on again. The conduction limit circuit disclosed in U.S. patent 3,855,520 provides a narrow "guard" pulse at the beginning of each conduction period to defeat the conduction limit circuit for a short interval and thus permit the power transistor switch to again turn on. The guard pulse must be of sufficient width to assure turning on of the slowest of the paralleled transistors which comprise the power switch under rated current conditions. During the guard pulse there is no protection for the power transistors. Further, the width of the guard pulse and the voltage threshold "triggering" level do not adapt to the changing conditions to which the power transistor switch may be subjected such as variations in temperature, switching time, or voltage.

The conduction limit arrangement of the present invention provides continuous power transistor switch protection that is tailored to the "safe operating area" of the power transistor switch and assures safe and flexible operation at any $V_{CE}$ value within the rating of the transistor. For example, safe operating area data is shown in the following table for a power switch using paralleled BUX20 transistors designed so that peak current does not exceed fifty amperes per transistor at 65°C heat sink temperature:

| $V_{CE}$ (volts) | $t_P$ (u sec) | $t_{RC}$ (u sec) |
|---|---|---|
| 3.75 | | 311 |
| 6.75 | 10,000 | 151 |
| 17.25 | 1,000 | 54 |
| 26.25 | 500 | 35 |
| 37.50 | 100 | 24 |
| 56.25 | 50 | 16 |
| 90.00 | 10 | 10 |

The first column illustrates the range of $V_{CE}$ voltages that may be experienced by the power transistor switch. The second column shows the length of time, $t_P$, that the transistor can sustain 50 amperes and the corresponding $V_{CE}$ voltage shown in column 1 without damage, the shortest time being at the highest VCE. The present invention

- 3 -

0012547

integrates $V_{CE}$ across the power transistor switch by means of an RC timing circuit, and the output of the RC timing circuit is an input to a voltage threshold detector set to switch at a predetermined "triggering" level to turn off the power switch. The third column of the above table shows the length of time ($t_{RC}$) required for such RC timing circuit to reach the predetermined triggering level (1.62 volts in the specific example) for the $V_{CE}$ value shown in column 1 of the table. The conduction limit protective circuit of the invention only reduces the duty cycle of the control pulse applied to a power transistor switch subjected to a $V_{CE}$ voltage shown in column 1 after the corresponding time $t_{RC}$ shown in column 3. In contrast, prior art conduction limit protective circuits would have used a 25 microsecond guard pulse for this power switch, and such prior circuit using a 25 microsecond guard pulse would have been too sensitive at low $V_{CE}$ values and not fast enough at high $V_{CE}$ values.

Accordingly it is an object of the invention to provide a conduction limit protective arrangement for a power switch which maintains the power switch within its safe operating area limits at all times and automatically changes such limits in accordance with the operating conditions to which the power switch is subjected, thereby permitting the power switch to carry maximum current while being fully protected at all times.

A conduction limit protective circuit in accordance with the present invention has an RC integrator timing circuit including a resistance in series with a capacitor connected to receive, as an input, the $V_{CE}$ voltage across a power transistor switch, threshold detector means for sensing when the voltage across the capacitor reaches a predetermined magnitude and for providing an output signal in response thereto, means for removing the control pulse from the power transistor switch in response to the output signal from the threshold detector means, whereby conduction by the transistor power switch is limited and it is turned off before damage can occur when it experiences abnormally high on-voltages and moves further into the active region, and means for discharging the capacitor of the RC timing circuit to a predetermined level subsequent to the termination of each control pulse so that timing begins from zero.

## BRIEF DESCRIPTION OF THE DRAWINGS

Fig 1 is a schematic circuit diagram of a pulse width modulation control embodying the invention;

Fig. 2 is a block diagram of the circuit of Fig. 1; and

Figs. 3 and 4 are simplified embodiments of the invention wherein the threshold "triggering" potential is established by the voltage drop across the diode junction of a transistor.

## DETAILED DESCRIPTION

Fig. 1 illustrates a pulse width modulation system incorporating a preferred embodiment of the invention which controls a DC series traction motor M having an armature A and field winding FLD for driving the wheels of a fork lift truck (not shown). Armature A may be connected in series with field winding FLD and a power transistor switch PS across the terminals of a battery BATT through the contacts F1 of a forward contactor and R2 of a reverse contactor to drive motor M in one direction to propel the lift truck forward or through the contacts R1 of the reverse contactor and F2 of the forward contactor to reverse motor M and propel the lift truck to the rear. Power switch PS may comprise a plurality of paralleled power transistors PS1-PS7 connected in a Darlington arrangement with a driver transistor Q2. Motor M is energized by unidirectional pulses of current from battery BATT conducted by power switch PS, and the speed of motor M is adjusted by a pulse width modulation control PWM shown only in block form which receives a succession of triggering pulses from an oscillator OSC and varies the width thereof in accordance with the position of the wiper of a speed potentiometer SPEED POT which is selectively controlled by a foot pedal FP on the lift truck. Control

PWM supplies variable width base drive current pulses to driver transistor Q2 of sufficient magnitude so that Q2 operates in saturation while PS1-PS7 are on and experience low voltage drop, and control PWM regulates the duty cycle of such pulses in accordance with the position of speed potentiometer SPEED POT to thereby vary the average voltage applied to motor M.

The emitter of power switch PS is grounded, and the collector-to-emitter voltage $V_{CE}$ across power switch PS is applied to an RC timing circuit integrator comprising a resistance R7 in series with a capacitor C1 having one electrode grounded. The voltage across capacitor C1 is coupled to the inverting input of a voltage threshold detector operational amplifier, or comparator COMP 1 whose noninverting input receives a fixed threshold voltage (for example 1.62 volts) derived at the junction of two resistances R3 and R4 connected in series as a voltage divider between a constant voltage source (preferably 12 volts) designated + and ground. When transistors PS1-PS7 of power switch are conducting during normal current levels, their collector-to-emitter voltage $V_{CE}$ is low with the result that the voltage across capacitor C1 is low and the output of threshold detector COMP 1 is positive (binary 1) because of the fixed positive binary 1 (or logic 1) voltage on its noninverting input. The output from comparator COMP 1 is coupled through a diode D1 to the inverting input of a comparator NAND 1 connected as a NAND logic gate. The inverting input of NAND 1 also receives a second input through a diode D2 from the $\bar{Q}$ output of a two microsecond monostable multivibrator MONO 1 and a third input through a diode D3 from the output of a comparator COMP 3 which re-inverts the variable width PWM control pulses.

The binary 1 voltage output from comparator COMP 1 is blocked by diode D1. When neither D1, D2 or D3 is conducting, a positive binary 1 voltage from voltage source + is coupled through a resistance R5 to the inverting input of logic gate NAND 1 to thereby maintain negative binary 0 voltage on its output. The output from gate NAND 1 is coupled through a resistance R6 to the base of a type PNP predriver transistor amplifier PRD, and the binary 0 output from NAND 1 maintains PRD in conduction.

When the paralleled power transistors PS1-PS7 experience abnormal current, the common collector-to-emitter voltage $V_{CE}$ increases to thereby charge capacitor C1 of the RC integrator through resistance R7 at a rate dependent upon the magnitude of $V_{CE}$. The time values $t_{RC}$ in the last column of the above table show the time intervals in microseconds required for the voltage across capacitor C1 of the RC integrator to reach the threshold voltage (1.62 volts) starting from zero volts for the corresponding $V_{CE}$ values in the first column of the table. Assume that after a time interval $t_{RC}$ capacitor C1 is charged to a voltage which exceeds the threshold (1.62 volts) voltage applied to the noninverting input of comparator COMP 1, thereby flipping the output of COMP 1 negative (binary 0). The binary 0 output from COMP 1 causes diode D1 to conduct and open logic gate NAND 1 so its output becomes positive (binary 1) as the result of the positive binary 1 voltage applied to the noninverting input of NAND 1 derived from a voltage divider comprising resistances R8 and R9 connected in series between the voltage source + and ground. The collector of predriver transistor PRD is coupled through a wave-shaping network WS to the base of driver transistor Q2 connected in a Darlington arrangement with the paralleled power transistors PS1-PS7, and the binary 1 output from gate NAND 1 turns off predriver transistor PRD to thereby remove the base drive current pulse from the power switch PS. Wave shaping network WS comprises a resistance R10 connected in parallel with the series arrangement of a resistance R11 and a capacitor C3 and "sharpens" the leading edge of the base drive current pulses applied to power switch PS.

The selectively variable width pulses from control PWM are applied through an input delay resistor- capacitor network DN to two-microsecond, edge-triggered monostable multivibrator MONO 1 so that the multivibrator is turned on after a two microsecond delay subsequent to the leading edge of the PWM pulse. Delay network DN verifies that a PWM pulse is an input for a fixed interval before timing is initiated by the monostable MONO 1. Network DN includes a comparator COMP 2 whose noninverting input receives a fixed binary 1 positive voltage derived at the junction of two resistances R13 and R14 connected in series as a voltage divider between voltage source + and ground so that the output of COMP 2 in the interim between PWM pulses is positive (binary 1) and is applied to the B trigger input (pin 5) of MONO 1. Each pulse from control PWM charges a capacitor C2 of the delay network DN through two series resistances R15 and R16. One electrode of capacitor C2 is grounded and its other electrode is coupled to the inverting input of comparator COMP 2. After a two microsecond delay subsequent to the leading edge of each PWM pulse capacitor C2 is charged to a sufficiently high voltage to flip the output of COMP 2 to binary 0 voltage which is applied to: (1) the B trigger input (pin 5) of the two second multivibrator MONO 1, and (2) the A trigger input (pin 12) of a 233 microsecond "inhibit" monostable multivibrator MONO 2. Multivibrators MONO 1 and MONO 2 may both be incorporated in a Motorola 14528 device and are of the edge-triggered type, and the negative-going transition applied to the B trigger input of MONO 1 turns it on so that it changes: (1) its Q output on pin 6 to binary 1 to turn on a capacitor-discharging transistor CDT and (2) its $\bar{Q}$ output on pin 7 to binary 0. The collector of transistor CDT is coupled to capacitor C1 of the RC integrator, and conduction by transistor CDT discharges capacitor C1 so that the timing intervals $t_{RC}$ provided by the RC integrator always begin from zero adjacent the leading edge of each pulse from control PWM. The binary 0 appearing on the $\bar{Q}$ output from the two microsecond monostable multivibrator MONO 1 when this multivibrator is turned on at the end of the two microsecond delay is coupled through diode D2 to the inverting input of logic gate NAND 1 to hold the output thereof at binary 1 voltage and thus maintain predriver transistor PRD off.

Comparator COMP 2 squares the edges of the PWM control pulses and also inverts the polarity thereof, and the output of COMP 2 is coupled to the inverting input of a comparator COMP 3 which "re-inverts" each PWM control pulse before it is coupled through diode D3 to the inverting input of logic gate amplifier NAND 1. When the output of COMP 2 goes to binary 0 voltage at the end of the two microsecond delay provided by network DN, the output of COMP 3 goes to binary 1 voltage so it does not affect logic gate NAND 1, and the output of NAND 1 is controlled by the $\bar{Q}$ output (binary 0) of the two microsecond multivibrator MONO 1. Multivibrator MONO 1 turns off after its period and changes: (1) its Q output to binary 0 to thereby turn off capacitor-discharging transistor CDT, and (2) its $\bar{Q}$ output to binary 1 voltage. When the $\bar{Q}$ output of MONO 1 goes to binary 1 voltage, the voltage source + coupled through resistance R5 to the inverting input of logic gate NAND 1 changes its output to binary 0 voltage and thereby turns on predriver transistor PRD and also turns on power switch PS.

The output of comparator COMP 2 is also coupled to the A trigger input (pin 12) of 233 microsecond "inhibit" monostable multivibrator MONO 2. Consequently, when the output of COMP 2 goes to binary zero at the end of the two microsecond delay, MONO 2 provides binary 0 voltage on its Q output which is coupled to the A trigger input (pin 4) of MONO 1, thereby locking out the two microsecond multivibrator MONO 1 during the 233 microsecond period to inhibit high frequency oscillations.

In order to trigger MONO 2, a low voltage must exist on its A input and a negative-going transition must be applied to its B input. When high voltage $V_{CE}$ across power switch PS triggers comparator COMP 1 into the conduction limit mode, such negative-going transition is applied to the B input of MONO 2. However, inasmuch as the period
of MONO 2 is 233 microseconds and MONO 1 is locked out
during this interval, repeated high frequency conduction
limit modes of power switch PS are prevented which might
otherwise cause too high switching losses and destroy
power switch PS.

The safe operating area characteristics of power
switch PS shown in the above table change with temperature, and a temperature dependent resistor TDR connected
in shunt to a capacitor C4 between the junction of R3 and
R4 and ground is subjected to the temperature of the power
switch heat sink and provides selective change of the
conduction limit characteristic with temperature.
Variations in the resistance of TDR with temperature
change the threshold voltage for comparator COMP 1 derived
at the junction of R3 and R4 in a direction to change the
$t_{RC}$ value of the integrator circuit to that which
corresponds to the voltage, current and temperature values
at which the power switch is being operated.

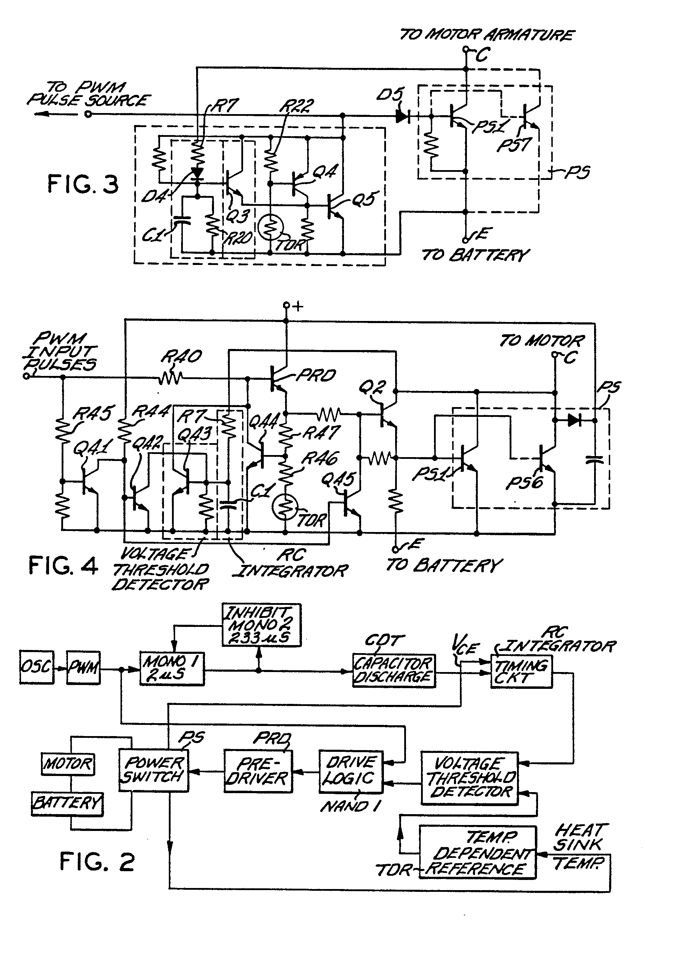

Fig. 3 illustrates an alternative embodiment of
the invention which is simplified in comparison to the
Fig. 1 circuit and can be plugged into, and provide the
conduction limit protection of the invention for, existing
power transistor switches. Fig. 3 does not show the PWM
pulse source and the motor which were illustrated in Fig.
1, and the Fig. 3 embodiment eliminates the two multi-
vibrators, the input pulse delay network, the predriver
and driver transistors, and the two microsecond time
interval for discharging the capacitor C1 of the
integrator as utilized in the Fig. 1 embodiment.

The collector-to-emitter voltage $V_{CE}$ of power
switch PS is applied to an RC integrator network
comprising resistance R7, a diode D4 and capacitor C1
which is in shunt with a resistance R20. The voltage
across capacitor C1 of the integrator is applied to a
threshold voltage detector, or comparator comprising the
base-emitter junction of a transistor Q3 in series with
the base-emitter junction of a base current drain transistor Q5. Comparator transistor Q3 compares the
voltage across capacitor C1 with a relatively fixed
voltage established by the voltage drop across the
base-emitter junction of Q3 in series with the voltage
drop across the base-emitter junction of transistor Q5
whose collector-to-emitter path is in shunt to the series
combination of the base-to-emitter junction of power
switch PS and diode D5.

The base drive current source (not shown) of
selectively variable width (PWM) pulses for the power
switch is preferably of the type having relatively low
impedance during the off period between (PWM) pulses such
as the constant current switching regulator disclosed in
U.S. patent 3,803,471 in which I am joint patentee with
R. G. Price and D. L. Moore, having the same assignee as
this invention, and such base drive source during the on
period supplies PWM pulses of sufficient amplitude through
a diode D5 to the base of power transistor PS to saturate
transistors PS1-PS7. Capacitor C1 discharges in the off
period between PWM pulses through resistance R20 and also
through the base-collector junction of Q3 in series with
the low impedance of the PWM pulse source. Transistor Q5
provides a shunt path to the power switch PS to permit
removal of base current from the power switch. During the
on period, the PWM pulse source provides base drive
current of sufficient magnitude to saturate PS, and the
base of Q3 assumes a potential of approximately 0.6 volts
relative to ground because of the voltage drop across its
base-emitter junction. However, this 0.6 volt potential
is not high enough to turn on the base-to-emitter junctions of transistors Q3 and Q5 in series. Consequently
power transistor PS will turn on adjacent the leading edge
of a PWM pulse because Q3 and Q5 will not turn on.
Capacitor C1 of the integrator charges through resistance
R7 from $V_{CE}$ across power switch PS, so power switch PS
must saturate before C1 charges up to a voltage equal to
the voltage drops across the base-emitter junctions of Q3
and Q5 in series since, if it does not, Q3 and Q5 will turn on and base current will be drained away from power switch PS through the emitter-collector path of Q5. If this occurs and base current is removed from power switch PS, its $V_{CE}$ will increase rapidly and thereby charge C1 more rapidly in a boot strap operation until Q5 drains away substantially all the base drive current from power switch PS.

A temperature protection transistor Q4 has its emitter and collector connected respectively to the collector and base of Q5 and has its base connected to a voltage divider comprising a resistance R22 and a negative temperature coefficient resistor TDR connected in series across the collector-emitter path of Q5. When the temperature of the power switch heat sink increases, the resistance of TDR decreases to provide base drive to Q4 which then increases its collector current flowing into the base of Q5 to change the threshold voltage level at which comparator transistor Q3 operates in a direction to maintain power switch PS within its safe operating area.

Fig. 4 illustrates another simplified embodiment of the invention wherein the relatively fixed voltage for the threshold detector, or comparator is derived across the base-emitter junction of a single (threshold voltage detector) transistor Q43 whose base is coupled to one electrode of capacitor C1 of the integrator.

The selectively variable width PWM base current drive pulses are coupled through a resistance R40 to the base of predriver transistor PRD connected as an emitter follower. The paralleled transistors PS1-PS6 of power switch PS are in a Darlington arrangement with driver transistor Q2 whose base is coupled to the emitter of predriver transistor PRD. The collector-to-emitter voltage $V_{CE}$ of power switch PS is coupled through resistance R7 to one electrode of capacitor C1. If $V_{CE}$ charges C1 in time $t_{RC}$ to a potential higher than the base-emitter drop of Q43, this transistor Q43 conducts and removes base drive from predriver transistor PRD, thereby also removing base drive from power switch PS so that it turns off, thereby increasing its $V_{CE}$ and providing more base drive to Q43 which tends to latch power switch PS off. Power switch PS is latched off until the PWM input pulse terminates.

A capacitor discharge transistor Q42 is analogous to transistor CDT of the Fig. 1 embodiment and has its emitter grounded and its collector coupled to one electrode of capacitor C1, and transistor Q42 is turned on at the trailing edge of each PWM pulse to discharge capacitor C1 so that the timing of the RC integrator circuit always starts from zero. The base of NPN transistor Q42 is coupled: (1) through a resistance R44 to the positive voltage source +, and (2) to the collector of a type NPN transistor Q41 whose emitter is grounded and whose base receives the PWM pulses through a resistor R45 so that Q41 is turned on at the leading edge of each PWM pulse to short the base-emitter junction of Q42 to turn it off, and Q41 is turned off at the trailing edge of each PWM pulse to turn on Q42 and thus discharge capacitor C1 in the interim between the PWM pulses. Each time Q41 is turned off at the trailing edge of a PWM pulse, it also removes the short from the base-emitter junction of Q45 so that this transistor turns on to remove base current drive from Q2 and cause power switch PS to turn off faster.

The base of predriver transistor PRD is connected to ground through the collector-emitter path of a transistor Q44. The emitter of PRD is connected to ground through the series arrangement of two resistances R47 and R46 and a positive temperature coefficient resistor TDR which is subjected to the temperature of the heat sink of power switch PS. The base of Q44 is coupled to the junction between R46 and R47. When power switch PS is heated to a dangerously high temperature, the resistance of TDR increases to the point where Q44 is turned on to remove base drive from driver transistor PRD and thus shunt the PWM pulses from power switch PS.

It will be appreciated that the embodiments of Fig. 1 can approach 100 percent modulation since the capacitor C1 of the RC integrator in this embodiment is not discharged in the off-time between PWM pulses in the manner of the Fig. 3 embodiment.

1.    A conduction limit protective arrangement for a power transistor switch PS comprising one or a plurality of paralleled power transistors regulated by a succession of control pulses which changes the conduction limit as a function of the switch operating conditions and permits it to carry maximum current while being fully protected at all times, characterized by,

an RC integrator circuit including a timing capacitor (C1) in series with a resistor (R7), the collector-to-emitter voltage across said power transistor switch being applied across said RC integrator circuit,

a comparator (COMP 1) for comparing the voltage across said timing capacitor to a relatively fixed threshold voltage and for providing an output signal when the former becomes equal to the latter,

a timing capacitor discharge circuit (MONO 1 and CDT) for discharging said timing capacitor to a predetermined voltage after the termination of each said control pulse, and

a control pulse removing circuit (D1, NAND 1, R6, PRD, Q2) responsive to said output signal from said comparator for removing said control pulse from said power transistor switch, whereby, if said power transistor experiences abnormally high on-voltages, it is turned off after a time interval which is a function of its collector-to-emitter voltage.

2.    A conduction limit protective arrangement according to claim 1 characterized in that said comparator includes the base-emitter junction of a transistor and said relatively fixed threshold voltage includes the potential drop across the base-to-emitter junction of said transistor.

3.    A conduction limit protective arrangement according to claim 1 or 2 characterized by a thermally dependent resistance for varying said threshold voltage as a function of the temperature of said power switch in a direction to decrease said threshold voltage as the temperature of said power switch increases.

4. A conduction limit protective arrangement according to claim 1, 2 or 3 characterized in that said timing capacitor discharge circuit is responsive to the leading edge of each control pulse.

5. A conduction limit protective arrangement according to claim 1, 2, 3 or 4 characterized in that said timing capacitor discharge circuit initiates discharge of said timing capacitor adjacent the trailing edge of each control pulse.

6. A conduction limit protective arrangement according to claim 1, 2, 3, 4 or 5 characterized in that said control pulses are provided by a pulse source which has a relatively low impedance in the interval between pulses and said timing capacitor discharge circuit includes said pulse source.

7. A conduction limit protective arrangement according to claim 1 characterized in that the collector-emitter path of a base current drain transistor is in shunt to the base-emitter path of said power switch and said control pulse removing circuit turns on said base current drain transistor.

8. A conduction limit protective arrangement according to claim 7 characterized in that collector-emitter path of said base current drain transistor is in shunt to the series arrangement of a diode and the base-emitter path of said power switch.

9. A conduction limit protective arrangement according to claim 1 characterized in that the collector-emitter path of a base current drain transistor is in shunt to the control pulse source, and said means for removing said pulse turns on said base current drain transistor.

10. A conduction limit protective arrangement according to any of the preceding claims characterized in that paralleled transistors normally operate in saturation, and said comparator provides said output signal when

- 16 -       0012547

said transistors come out of saturation and move in the active region.

11.    A conduction limit protective arrangement according to any of the preceding claims characterized in that said parallel transistors are in a Darlington arrangement with a driver transistor which normally operates in saturation and said comparator provides said output signal when said transistors experience sufficiently high on voltage to cause said driver transistor to come out of saturation and move into the active region.

FIG. I

FIG. 3

FIG. 4

FIG. 2

**European Patent Office**

**EUROPEAN SEARCH REPORT**

00 12547

Application number

EP 79 30 2752

| Category | Citation of document with indication, where appropriate, of relevant passages | Relevant to claim |
|---|---|---|
| X | US - A- 3 946 280 (E.G. QUIST) <br> * column 2, line 1 to line 21; column 4, line 11 to column 5, line 55; fig. 2 * <br> --- | 1,2,7 |
| A | DE - B - 1 513 057 (SIEMENS AG) <br> * claim 1; fig. 1 * <br> --- | 3 |
| | US - A - 4 016 459 (A. BOEHRINGER) <br> * abstract; fig. 4 * <br> --- | 10,11 |
| A | DE - A - 1 438 702 (SIEMENS AG) <br> * claim 1; fig. 4 * <br> --- | |
| A | US - A- 4 074 334 (S. D'ARRIGO et al.) <br> * abstract; fig. 2 * <br> --- | |
| A | ELEKTRONIK, No. 5, 1977 <br> München <br> H.-W. LÜTJENS "Schaltregler mit hoch-spannungsfestem Transistor für Per-manentmagnet-Motoren" <br> pages 73 to 79 <br> * pages 75 to 76; fig. 6, 7, 8 * <br> ---- | |

## DOCUMENTS CONSIDERED TO BE RELEVANT

### CLASSIFICATION OF THE APPLICATION (Int. Cl.)

B 60 L   15/00

H 02 H   7/20

H 03 K   17/08

### TECHNICAL FIELDS SEARCHED (Int.Cl.)

B 60 L   15/00

H 02 H   7/20

H 03 K   17/08

### CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| Berlin | 19-03-1980 | LEMMERICH |

EPO Form 1503.1   06.78